# EUROPEAN PATENT SPECIFICATION

(11) **EP 4 148 795 B1**
(45) Date of publication and mention of the grant of the patent: **25.11.2026**
(21) Application number: 20917294.9
(22) Date of filing: 23.06.2020
(51) Int. Cl.: H10K 59/124, H10K 59/131, H10K 59/80, H10K 71/00, H10K 71/20

(54) **FLEXIBLE DISPLAY PANEL AND MANUFACTURING METHOD THEREFOR**
FLEXIBLE ANZEIGETAFEL UND HERSTELLUNGSVERFAHREN DAFÜR
PANNEAU D'AFFICHAGE FLEXIBLE ET SON PROCÉDÉ DE FABRICATION

(30) Priority: 27.04.2020 CN 202010341431
(43) Date of publication of application: 15.03.2023
(73) Proprietor: Wuhan China Star Optoelectronics Semiconductor Display Technology Co., Ltd., Wuhan, Hubei 430079 (CN)
(72) Inventor: ZHAO, Huihui, Wuhan Hubei 430079 (CN)
(74) Representative: Murgitroyd & Company
(86) International application number: PCT/CN2020/097814
(87) International publication number: WO 2021/217841

(56) References cited:
- WO-A1-2019/064534
- CN-A- 107 910 335
- CN-A- 108 231 800
- CN-A- 109 300 964
- CN-A- 109 360 830
- CN-A- 109 671 719

## Description

### BACKGROUND

### Technical Field

The present invention relates to a field of display technology and in particular, to a flexible display panel and a manufacturing method thereof.

### Related Art

In recent years, organic light-emitting diode (OLED) displays have received great attention and been used extensively due to advantages such as a high contrast ratio, wide viewing angles, and flexibility. Especially, the flexibility feature grabs attention from the majority of users. As the technology becomes mature, flexible and foldable displays also appear on the market.

The flexible and foldable display needs to be rolled or bent during use, and even frequently bent. As the number of bending increases, it is easy to cause the resistance of traces in the source/drain metal layer to increase, which leads to lower brightness of the display and broken traces in source/drain metal layer, thus causing poor display performance.

CN109300964A is a related art. It provides a flexible OLED panel including a display area for configuring a pixel structure, the display area including a plurality of first bendable structures extending along a first direction, a plurality of second bendable structures extending along a second direction and a display unit. The second bendable structure intersects the first bendable structure to form a plurality of sub-display areas. The display unit is disposed in the sub-display area, and the display unit includes at least one sub-pixel.

In summary, it is necessary to provide a new flexible display panel and a manufacturing method thereof to solve the above technical problems.

### SUMMARY

The present invention provides a flexible display panel and a manufacturing method thereof according to the claims to solve the problem that with a continuous increase in the number of bending of a conventional flexible display panel, resistance of traces in a source/drain metal layer tends to increase, resulting in a decrease in brightness and broken traces in the source/drain metal layer.

To solve the above problems, the present invention provides a technical solution as follows:
The present invention provides a flexible display panel which comprises a bending region and a non-bending region, the flexible display panel comprising:
a base substrate
an inorganic layer arranged on the base substrate;
an organic filling layer arranged on the inorganic layer;
source/drain metal layer traces disposed on the organic filling layer, the source/drain metal layer traces comprising a first source/drain metal layer trace arranged in the bending region and a second source/drain metal layer trace arranged in the non-bending region; and
a planarization layer arranged at one side of the source/drain metal layer away from the base substrate.

In the flexible display panel according to the present invention, the inorganic layer comprises:
a moisture barrier layer arranged on the base substrate;
a buffer layer arranged on the moisture barrier layer;
an active layer arranged on the buffer layer;
a first insulating layer covering the buffer layer and the active layer;
a first gate layer trace arranged on the first insulating layer;
a second insulating layer covering the first insulating layer and the first gate layer trace;
a second gate layer trace arranged on the second insulating layer; and
an interlayer dielectric layer covering the second insulating layer and the second gate layer trace;
wherein the source/drain layer traces are disposed on the organic filling layer, the source/drain metal layer traces are connected to the active layer through a first via hole extended through the first insulating layer, the second insulating layer, and the interlayer dielectric layer, and the organic filling layer is arranged between the source/drain metal layer traces and the interlayer dielectric layer.

In the flexible display panel according to the present invention, the organic filling layer is provided with at least one groove structure arranged in an area corresponding to the bending region and disposed on one side away from the base substrate, and the first source/drain metal layer trace forms a curved trace through the groove structure, wherein at least a portion of the groove structure completely penetrates the organic filling layer, and wherein the first source/drain metal layer trace, where the organic filling layer is penetrated, is positioned between the interlayer dielectric layer below, the organic filling layer at least partially around it, and the planarization layer above.

In the flexible display panel according to one embodiment of the present invention, a bottom portion of the groove structure is in contact with the organic filling layer, and the first source/drain metal layer trace is arranged between the organic filling layer and the planarization layer.

In the flexible display panel according to one embodiment of the present invention, an aperture diameter of the groove structure ranges from 2um to 20um.

In the flexible display panel according to one embodiment of the present invention, a depth of the groove structure ranges from 0.5um to 1.5um.

In the flexible display panel according to one embodiment of the present invention, a cross-sectional shape of the groove structure comprises a trapezoid, a rectangle, a square, a circle, a diamond, or a triangle.

In the flexible display panel according to one embodiment of the present invention, the flexible display panel further comprises a second via hole defined in the bending region, the second via hole is extended through the interlayer dielectric layer, the second insulating layer, the first insulating layer, and the buffer layer, and the organic filling layer is filled in the second via hole.

In the flexible display panel according to one embodiment of the present invention, the buffer layer is made of silicon nitride or silicon oxide.

The present invention provides a manufacturing method of a flexible display panel according to the claims, comprising following steps:
S10: providing a base substrate;
S20: forming an inorganic layer on the base substrate;
S30: forming an organic filling layer on the inorganic layer, and patterning the organic filling layer, so that the organic filling layer forms at least one groove structure arranged in an area corresponding to the bending region and disposed on one side away from the base substrate;
S40: forming source/drain metal layer traces on the organic filling layer, and patterning the source/drain metal layer to form a first source/drain metal layer trace in the bending region and a second source/drain metal layer trace in the non-bending region, wherein the first source/drain metal layer trace forms a curved trace through the groove structure; and
S50: forming a planarization layer on the source/drain metal layer trace.

In the manufacturing method of the flexible display panel, step S20 comprises following steps:
S201: sequentially forming a moisture barrier layer, a buffer layer, an active layer, a first insulating layer, a first gate layer trace, a second insulating layer, a second gate layer trace, and an interlayer dielectric layer on the base substrate; and
S202: forming a second via hole extended through the first insulating layer, the second insulating layer, and the interlayer dielectric layer.

In the flexible display panel and the manufacturing method thereof provided by the present invention, the source/drain metal layer trace is a curved trace, so that when the flexible display panel is bent, the source/drain metal layer trace is subjected to alternate compressive stress and tensile stress, and the compressive stress and tensile stress can neutralize each other. Accordingly, the stress is reduced, thereby reducing a resistance change of the source/drain metal layer trace caused by bending, and further reducing an optical change caused by the resistance change. At the same time, the present invention can reduce a risk of breakage of the source/drain metal layer trace and improve product performance of the flexible display panel.

### BRIEF DESCRIPTION OF THE DRAWINGS

In order to more clearly illustrate the embodiments of the present disclosure or related art, figures which will be described in the embodiments are briefly introduced hereinafter. It is obvious that the drawings are merely for the purposes of illustrating some embodiments of the present disclosure, and a person having ordinary skill in this field can obtain other figures according to these figures without inventive work.
FIG. 1 is a schematic plan view illustrating a structure of a flexible display panel according to one embodiment of the present invention;
FIG. 2 is a schematic cross-sectional view, taken along line A-A, illustrating the flexible display panel according to one embodiment of the present invention;
FIG. 3 is a schematic cross-sectional view, taken along line B-B, illustrating a flexible display panel not forming part of the present invention;
FIG. 4 is a schematic cross-sectional view, taken along line B-B, illustrating the flexible display panel according to one embodiment of the present invention;
FIG. 5 is a process flow diagram illustrating a manufacturing method of the flexible display panel according to one embodiment of the present invention; and
FIGs. 6A to 6G are schematic views illustrating the manufacturing method of the flexible display panel according to one embodiment of the present invention.

### DETAILED DESCRIPTION

A description is provided below with reference to the accompanying drawings to illustrate specific embodiments of the present invention. The directional terms mentioned in the present invention, such as "upper", "lower", "front", "rear", "left", "right", "inner", "outer", and "lateral", are for illustrative purposes based on the accompanying drawings. Therefore, the directional terms are only used to describe and understand the present invention, rather than to limit the present invention. In the drawings, structurally similar elements are indicated by the same reference numerals.

The present invention solves a problem with a conventional flexible display panel. The problem is that, as the number of bending increases, resistance of traces of a source/drain metal layer tends to increase, resulting in a decrease in brightness and breakage of the traces of the source/drain metal layer. The present invention can solve this problem.

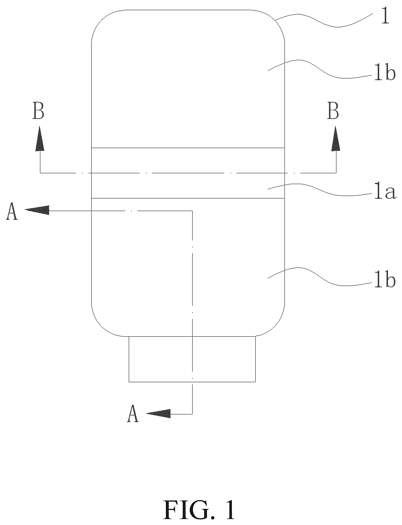

As shown in FIG. 1, a flexible display panel 1 is provided according to one embodiment of the present invention. The flexible display panel 1 includes a display region. An integrated chip and a flexible circuit board are arranged at an edge of the display region. The display region comprises a bending region 1a and a non-bending region 1b. The bending region 1a refers to an area that needs to be bent or folded. The non-bending region 1b refers to an area that does not need to be bent or folded. The bending region 1a and the non-bending region 1b both can be used to display images. The bending region 1a can be arranged at any position of the display region. In consideration of user habits, the bending region 1a of the present embodiment is arranged in the middle of the display region, and the flexible display panel 1 can be bent or folded along a bending axis of the bending region 1a.

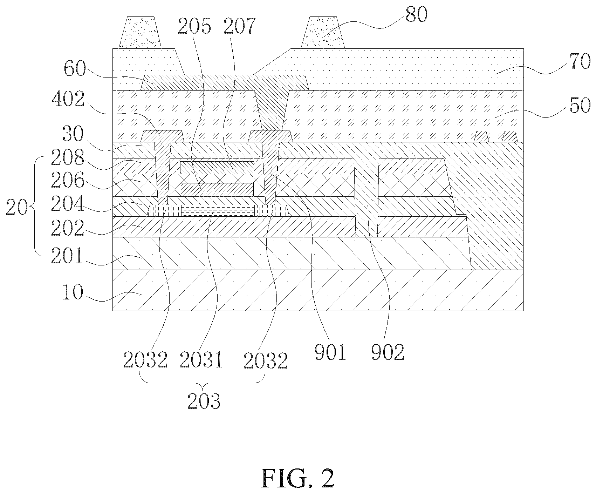

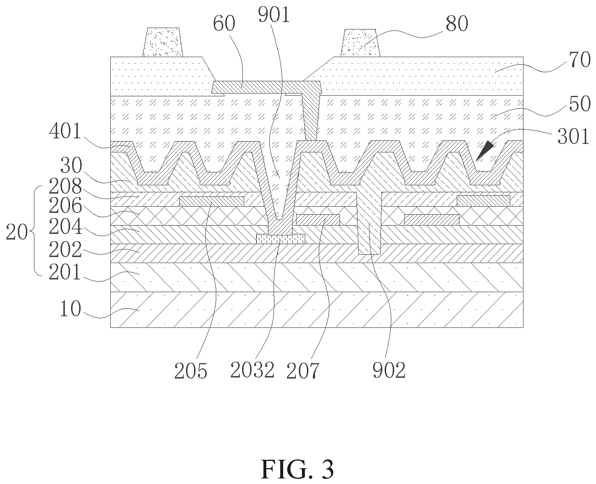

As shown in FIGs. 2 and 3, structurally, the flexible display panel 1 comprises an array substrate, and the array substrate comprises a base substrate 10. The base substrate 10 is a flexible substrate, which can be made of a polyamide material.

An inorganic layer 20 is arranged on the base substrate 10. It should be noted that the inorganic layer 20 comprises, but is not limited to, a moisture barrier layer (an oxygen and moisture barrier layer) 201, a buffer layer 202, an active layer 203, a first insulating layer 204, a first gate layer trace 205, a second insulating layer 206, a second gate layer trace 207, and an interlayer dielectric layer 208. In the present embodiment, the inorganic layer 20 comprises: the moisture barrier layer 201 arranged on the base substrate 10, wherein the moisture barrier layer 201 is configured to prevent external moisture or oxygen from corroding a device layer of the flexible display panel 1; the buffer layer 202 arranged on the moisture barrier layer 201, wherein the buffer layer 202 can be made of silicon nitride or silicon oxide for buffering and protection; the active layer 203 arranged on the buffer layer 202, wherein the active layer 203 can be made of polysilicon or amorphous silicon, and the active layer 203 comprises a semiconductor region 2031 arranged in the middle and doped regions 2032 arranged at two ends of the semiconductor region 2031; the first insulating layer 204 covering the buffer layer 202 and the active layer 203; the first gate layer trace 205 arranged on the first insulating layer 204; the second insulating layer 206 covering the first insulating layer 204 and the first gate layer trace 205; the second gate layer trace 207 arranged on the second insulating layer 206; and the interlayer dielectric layer 208 covering the second insulating layer 206 and the second gate layer trace 207.

**In** detail, the first gate layer trace 205 and the second gate layer trace 207 can be made of metals or alloys containing molybdenum, copper, and etc. The first insulating layer 204, the second insulating layer 206, and the interlayer dielectric layer 208 can be made of silicon oxide, silicon nitride, or other materials.

An organic filling layer 30 is arranged on the inorganic layer 20, and the organic filling layer 30 can be made of a flexible organic material such as PI**.** Source/drain metal layer traces are arranged on the organic filling layer 30. The source/drain metal layer trace includes a first source/drain metal layer trace 401 located in the bending region 1a and a second source/drain metal layer trace 402 located in the non-bending region 1b. The source/drain metal layer trace can be made of metals or alloys containing molybdenum, copper, and etc. The source/drain metal layer trace is connected to the doped region 2032 of the active layer 203 through a first via hole 901 extended through the first insulating layer 204, the second insulating layer 206, and the interlayer dielectric layer 208. The organic filling layer 30 is arranged between the source/drain metal layer trace and the interlayer dielectric layer 208.

Because molybdenum and copper have lower hardness, when the flexible display panel 1 is bent, the first source/drain metal layer trace 401 tends to break. At the same time, as the number of bending increases, it is easy to cause the resistance of the first source/drain metal layer trace 401 to increase, resulting in a decrease in the brightness. Therefore, the first source/drain metal layer trace 401 located in the bending region 1a is designed as a curved trace, so that the first source/drain metal layer trace 401 receives alternate compressive stress and tensile stress, and the compressive stress and the tensile stress can neutralize each other, which effectively reduces a risk of trace breakage, and at the same time, reduces an optical change caused by the resistance change of the first source/drain metal layer trace 401 to improve product performance.

Furthermore, in the present embodiment, the organic filling layer 30 is provided with at least one groove structure 301 arranged in an area corresponding to the bending region 1a and disposed on one side away from the base substrate 10, and the first source/drain metal layer trace 401 forms the curved trace through the groove structure 301.

In one reference embodiment not forming part of the present invention, as shown in FIG. 3, the groove structure 301 does not completely penetrate the organic filling layer 30, and a bottom of the groove structure 301 is in contact with the organic filling layer 30. The first source/drain metal layer trace 401 is disposed between the organic filling layer 30 and the planarization layer 50. The planarization layer 50 is arranged on the source/drain metal layer trace.

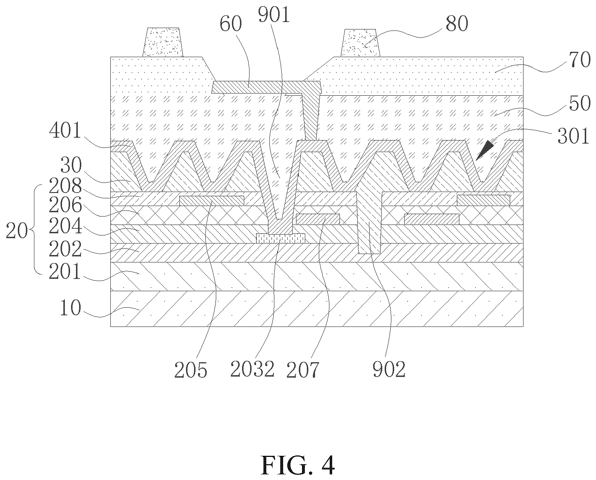

In the present invention, as shown in FIG. 4, the groove structure 301 completely penetrates the organic filling layer 30, and the first source/drain metal layer trace 401 is arranged among the interlayer dielectric layer 208, the organic filling layer 30, and the planarization layer 50.

The groove structure 301 includes crests and troughs. When the flexible display panel 1 is folded inward (bent to one side close to the base substrate 10), the first source/drain metal layer trace 401 is subjected to tensile stress at the crests of the groove structure 301 and compressive stress at the troughs of the groove structure 301, so the tensile stress and the compressive stress at the crests and the troughs can neutralize each other. Similarly, the tensile stress and the compressive stress of the first source/drain metal layer trace 401 at the crests and troughs can neutralize each other. When the flexible display panel 1 is folded outward (bent toward one side away from the base substrate 10), the first source/drain metal layer trace 401 is subjected to compressive stress at the crests of the groove structure 301 and tensile stress at the troughs of the groove structure 301. Therefore, the compressive stress and the tensile stress at the crests and the troughs can neutralize each other, thereby reducing overall stress on the first source/drain metal layer trace 401.

Specifically, when the flexible display panel 1 is bent, positions of the bending region 1a are subjected to uniform stress, so the groove structures 30 are evenly spaced in a direction perpendicular to the axis of the bending region 1a. In one embodiment of the present invention, a thickness of the organic filling layer 30 is 1.5um, an aperture diameter of the groove structure 301 ranges from 2um to 20um, and a depth of the groove structure 301 ranges from 0.5um to 1.5um. It should be noted that the thickness of the organic filling layer 30, the aperture diameter of the groove structure 301, and the depth of the groove structure 301 can be designed according to actual conditions of the flexible display panel 1.

In detail, a cross-sectional shape of the groove structure 301 comprises a trapezoid, a rectangle, a square, a circle, a diamond, a triangle, or a special shape. However, the present invention is not intended to limit the cross-sectional shape of the groove structure 301.

Furthermore, the flexible display panel 1 further comprises a second via hole 902 arranged in the bending region 1a, and the second via hole 902 penetrates the interlayer dielectric layer 208, the second insulating layer 206, the first insulating layer 204, and the buffer layer 202. The organic filling layer 30 is filled in the second via hole 902. The organic filling layer 30 can adjust stress between the upper and lower film layers in the inorganic layer 20, and can spread the stress of the inorganic layer 20 during bending to thereby prevent breakage of the first source/drain metal layer trace 401.

The flexible display panel 1 further comprises an anode layer 60 disposed on the planarization layer 50, a pixel definition layer 70, and a spacer layer 80 disposed on the pixel definition layer 70, wherein a light-emitting layer is arranged in an opening area of the pixel definition layer 70.

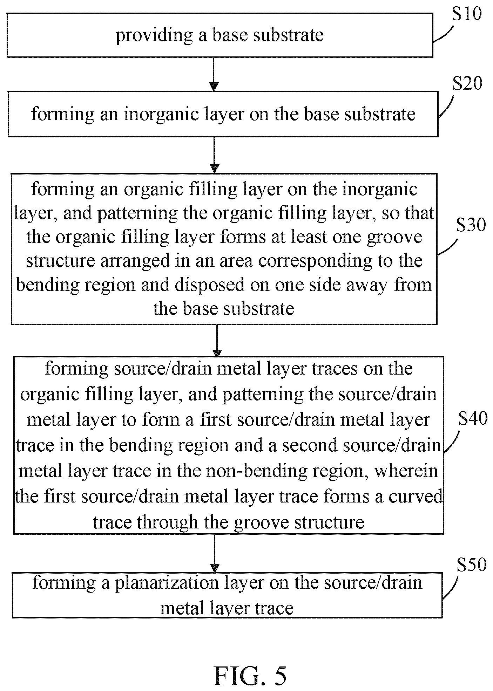

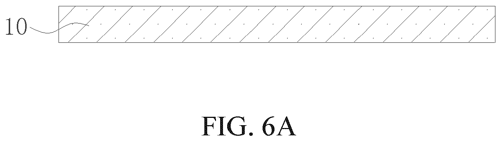

As shown in FIG. 5, a manufacturing method of a flexible display panel 1 is provided according to the claims of the present invention. The manufacturing method comprises the following steps:
As shown in FIG. 6A, step S10: providing a base substrate 10.

The base substrate 10 is flexible substrate.

Step S20: forming an inorganic layer 20 on the base substrate 10.

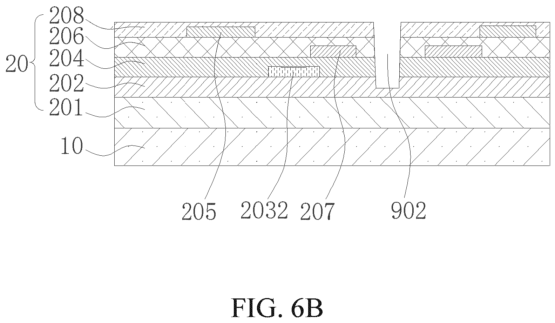

Referring to FIG. 6B, step S20 comprises the following steps:
S201: sequentially forming a moisture barrier layer 201, a buffer layer 202, an active layer 203, a first insulating layer 204, a first gate layer trace 205, a second insulating layer 206, a second gate layer trace 207, and an interlayer dielectric layer 208 on the base substrate 10.

First, the moisture barrier layer 201 and the buffer layer 202 can be formed by chemical vapor deposition, and then the active layer 203 can be formed by crystallization, exposure, and etching by performing an excimer laser annealing method. Next, the first insulating layer 204 can be formed by chemical vapor deposition. After that, a first metal layer is formed by radio frequency sputtering, and exposed and etched to form the first gate layer trace 205. Afterwards, the second insulating layer 206 is formed by chemical vapor deposition; a second metal layer is formed by radio frequency sputtering, and exposed and etched to form the second gate layer trace 207. Finally, the interlayer dielectric layer 208 is formed by chemical vapor deposition.

Step S202: forming a second via hole 902 extended through the first insulating layer 204, the second insulating layer 206, and the interlayer dielectric layer 208.

The first insulating layer 204, the second insulating layer 206, and the interlayer dielectric layer 208 are exposed and developed to form the second via hole 902.

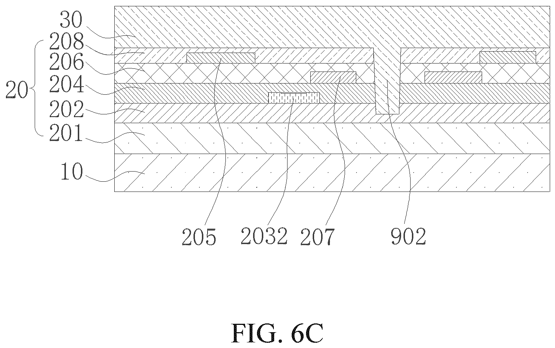

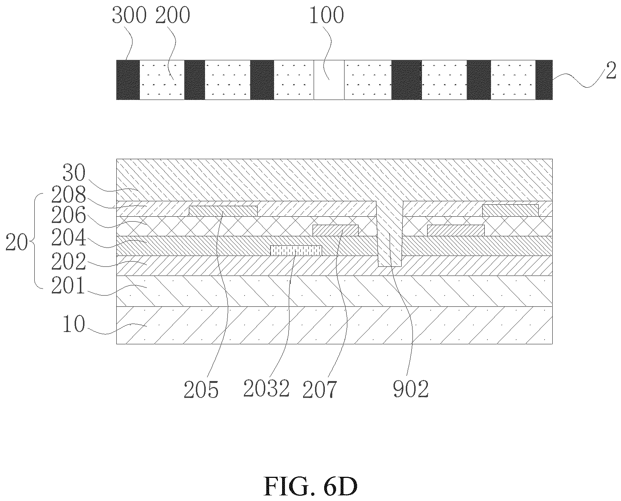

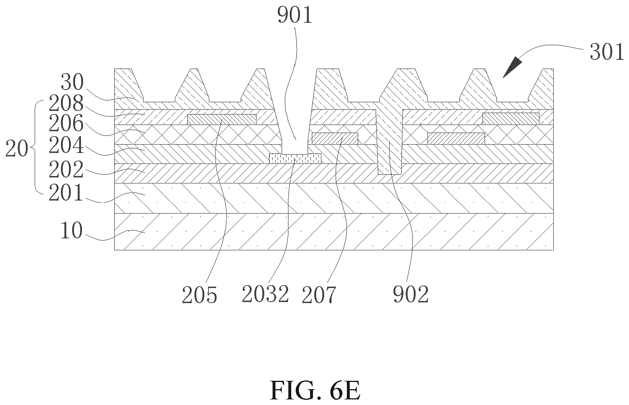

As shown in FIGs. 6C, 6D, and 6E, step S30: forming an organic filling layer 30 on the inorganic layer 20, and patterning the organic filling layer 30, so that the organic filling layer 30 forms at least one groove structure 301 in an area corresponding to the bending region 1a and on one side away from the base substrate 10.

The organic filling layer 30 can be formed on the interlayer dielectric layer 208 by coating, and the organic filling layer 30 can be exposed by using a halftone mask 2. The halftone mask 2 comprises a light-transmissive region 100, a semi-transmissive region 200, and a non-transmissive region 300. The light-transmissive region 100 is arranged corresponding to an area where the first via hole 901 needs to be formed in the flexible display panel 1, the semi-transmissive region 200 is arranged corresponding to an area where the groove structure 301 needs to be formed in the flexible display panel 1, and the non-transmissive region 300 is arranged corresponding to the rest area of the flexible display panel 1.

The halftone mask 2 can be used to make the first via hole 901 and the groove structure 301 at the same time, thus saving manufacturing steps and improving production efficiency. Certainly, another mask with a different structure can be used to prepare the first via hole 901 and the groove structure 301 successively, and a detailed description thereof is not provided here for brevity.

Specifically, a thickness of the organic filling layer 30 is 1.5um, an aperture diameter of the groove structure 301 ranges from 2um to 20um, a depth of the groove structure 301 ranges from 0.5um to 1.5um, and the groove structure 301 completely penetrates (in the method according the present invention) or does not completely penetrate (in the method not according the present invention) the organic filling layer 30; a cross-sectional shape of the groove structure 301 is a trapezoid, a rectangle, a square, a circle, a diamond, a triangle, or a special shape (e.g., an irregular hole).

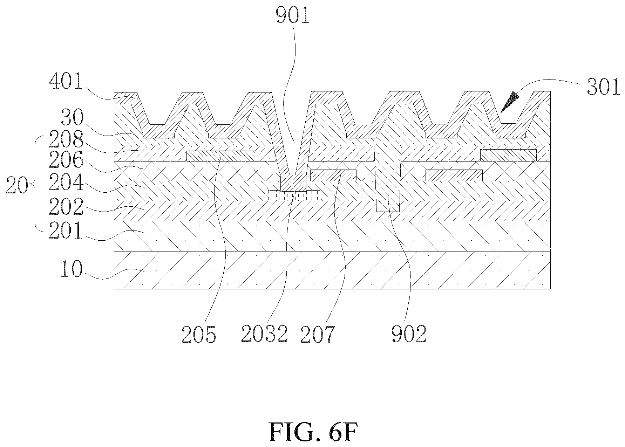

As shown in FIG. 6F, step S40: forming a source/drain metal layer on the organic filling layer 30, and patterning the source/drain metal layer to form a first source/drain metal layer trace 401 in the bending region 1a and a second source/drain metal layer trace 402 in the non-bending region 1b, wherein the first source/drain metal layer trace 401 forms a curved trace through the groove structure 301.

The source/drain metal layer trace can be formed by sputtering.

It should be noted that in step S40, patterning the organic filling layer 30 includes exposure, development, etching, and etc., which can also form the first via hole 901 penetrating the first insulating layer 204, the second insulating layer 206, and the interlayer dielectric layer 208, wherein the first via hole 901 is connected to the active layer 203.

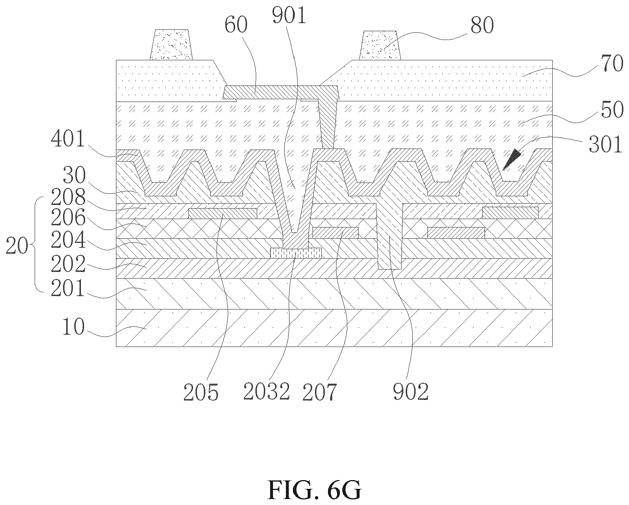

As shown in FIG. 6G, step S50: forming a planarization layer 50 on the source/drain metal layer traces.

At the same time, the manufacturing method of the flexible display panel 1 further comprises forming an anode layer 60, a pixel definition layer 70, and a spacer layer 80 on the planarization layer 50, and the anode layer 60 is connected to the source/drain metal layer trace through the via hole.

Advantages of the present invention: **In** the flexible display panel 1 and the manufacturing method thereof provided by the present invention, the source/drain metal layer trace is designed as a curved trace, so that when the flexible display panel 1 is bent, the source/drain metal layer trace is subjected to alternate compressive stress and tensile stress, and thereby the compressive stress and the tensile stress can neutralize each other to reduce the stress. Such a configuration reduces the resistance change of the source/drain metal layer trace caused by bending, thereby reducing the optical change caused by the resistance change. At the same time, the present invention can reduce the risk of breakage of the source/drain metal layer trace, and improve the product performance of the flexible display panel 1.

## Claims

1. A flexible display panel (1), comprising a bending region (1a) and a non-bending region (1b), wherein the flexible display panel (1) comprises:
a base substrate (10);
an inorganic layer (20) arranged on the base substrate (10);
an organic filling layer (30) arranged on the inorganic layer (20);
source/drain metal layer traces disposed on the organic filling layer (30), the source/drain metal layer traces comprising a first source/drain metal layer trace (401) arranged in the bending region (1a) and a second source/drain metal layer trace (402) arranged in the non-bending region (1b); and
a planarization layer (50) arranged at one side of the source/drain metal layer traces away from the base substrate (10);
wherein the inorganic layer (20) comprises:
a moisture barrier layer (201) arranged on the base substrate (10);
a buffer layer (202) arranged on the moisture barrier layer (201);
an active layer (203) arranged on the buffer layer (202);
a first insulating layer (204) covering the buffer layer (202) and the active layer (203);
a first gate layer trace (205) arranged on the first insulating layer (204);
a second insulating layer (206) covering the first insulating layer (204) and the first gate layer trace (205);
a second gate layer trace (207) arranged on the second insulating layer (206); and
an interlayer dielectric layer (208) covering the second insulating layer (206) and the second gate layer trace (207);
wherein the source/drain metal layer traces are disposed on the organic filling layer (30), the source/drain metal layer traces are connected to the active layer (203) through a first via hole (901) extended through the first insulating layer (204), the second insulating layer (206), and the interlayer dielectric layer (208), and the organic filling layer (30) is arranged between the source/drain metal layer traces and the interlayer dielectric layer (208);
wherein the organic filling layer (30) is provided with at least one groove structure (301) arranged in an area corresponding to the bending region (1a) and disposed on one side away from the base substrate (10), and the first source/drain metal layer trace (401) forms a curved trace through the groove structure (301),
wherein at least a portion of the groove structure (301) completely penetrates the organic filling layer (30); and wherein the first source/drain metal layer trace (401), where the organic filling layer (30) is penetrated, is positioned between the interlayer dielectric layer (208) below, the organic filling layer (30) at least partially around it, and the planarization layer (50) above.

2. The flexible display panel (1) according to claim 1, wherein a bottom portion of the groove structure (301) is in contact with the organic filling layer (30), and the first source/drain metal layer trace (401) is arranged between the organic filling layer (30) and the planarization layer (50).

3. The flexible display panel (1) according to claim 1, wherein an aperture diameter of the groove structure (301) ranges from 2um to 20um.

4. The flexible display panel (1) according to claim 1, wherein a depth of the groove structure (301) ranges from 0.5um to 1.5um.

5. The flexible display panel (1) according to claim 2, wherein a cross-sectional shape of the groove structure (301) comprises a trapezoid, a rectangle, a square, a circle, a diamond, or a triangle.

6. The flexible display panel (1) according to claim 1, wherein the flexible display panel (1) further comprises a second via hole defined in the bending region (1a), the second via hole is extended through the interlayer dielectric layer, the second insulating layer, the first insulating layer, and the buffer layer, and the organic filling layer (30) is filled in the second via hole.

7. The flexible display panel (1) according to claim 1, wherein the buffer layer is made of silicon nitride or silicon oxide.

8. A manufacturing method of a flexible display panel (1) according to claim 1, comprising the following steps:
S10: providing a base substrate (10);
S20: forming an inorganic layer (20) on the base substrate (10);
S30: forming an organic filling layer (30) on the inorganic layer (20), and patterning the organic filling layer (30), so that the organic filling layer (30) forms at least one groove structure (301) arranged in an area corresponding to the bending region (1a) and disposed on one side away from the base substrate (10);
S40: forming source/drain metal layer traces on the organic filling layer (30), and patterning the source/drain metal layer to form a first source/drain metal layer trace (401) in the bending region (1a) and a second source/drain metal layer trace (402) in the non-bending region (1b), wherein the first source/drain metal layer trace (401) forms a curved trace through the groove structure (301); and
S50: forming a planarization layer (50) on the source/drain metal layer trace,
wherein the inorganic layer (20) comprises:
a moisture barrier layer (201) arranged on the base substrate (10);
a buffer layer (202) arranged on the moisture barrier layer (201);
an active layer (203) arranged on the buffer layer (202);
a first insulating layer (204) covering the buffer layer (202) and the active layer (203);
a first gate layer trace (205) arranged on the first insulating layer (204);
a second insulating layer (206) covering the first insulating layer (204) and the first gate layer trace (205);
a second gate layer trace (207) arranged on the second insulating layer (206); and
an interlayer dielectric layer (208) covering the second insulating layer (206) and the second gate layer trace (207);
wherein the source/drain metal layer traces are disposed on the organic filling layer (30), the source/drain metal layer traces are connected to the active layer (203) through a first via hole (901) extended through the first insulating layer (204), the second insulating layer (206), and the interlayer dielectric layer (208), and the organic filling layer (30) is arranged between the source/drain metal layer traces and the interlayer dielectric layer (208);
wherein the organic filling layer (30) is provided with at least one groove structure (301) arranged in an area corresponding to the bending region (1a) and disposed on one side away from the base substrate (10), and the first source/drain metal layer trace (401) forms a curved trace through the groove structure (301),
wherein at least a portion of the groove structure (301) completely penetrates the organic filling layer (30), and wherein the first source/drain metal layer trace (401), where the organic filling layer (30) is penetrated, is positioned between the interlayer dielectric layer (208) below, the organic filling layer (30) at least partially around it, and the planarization layer (50) above.

## Patentansprüche

1. Ein flexibles Anzeigepanel (1), das einen biegbaren Bereich (1a) und einen nicht biegsamen Bereich (1b) umfasst, wobei das flexible Anzeigepanel (1) Folgendes umfasst:
ein Basissubstrat (10);
eine auf dem Basissubstrat (10) angeordnete anorganische Schicht (20);
eine organische Füllschicht (30), die auf der anorganischen Schicht (20) angeordnet ist;
auf der organischen Füllschicht (30) angeordnete Leiterbahnen der Source-/Drain-Metallschicht, wobei die Leiterbahnen der Source-/Drain-Metallschicht eine erste, im Biegebereich (1a) angeordnete Leiterbahn (401) und eine zweite, im nicht biegsamen Bereich (1b) angeordnete Leiterbahn (402) umfassen; und
eine Planarisierungsschicht (50), die auf einer Seite der Source-/Drain-Metallschicht-Leiterbahnen, abseits des Basissubstrats (10), angeordnet ist;
wobei die anorganische Schicht (20) Folgendes umfasst:
eine auf dem Basissubstrat (10) angeordnete Feuchtigkeitssperrschicht (201);
eine auf der Feuchtigkeitssperrschicht (201) angeordnete Pufferschicht (202);
eine auf der Pufferschicht (202) angeordnete aktive Schicht (203);
eine erste Isolierschicht (204), die die Pufferschicht (202) und die aktive Schicht (203) bedeckt;
eine erste Gate-Leiterbahn (205), die auf der ersten Isolierschicht (204) angeordnet ist;
eine zweite Isolierschicht (206), die die erste Isolierschicht (204) und die erste Gate-Leiterbahn (205) bedeckt;
eine zweite Gate-Leiterbahn (207), die auf der zweiten Isolierschicht (206) angeordnet ist; und
eine Zwischenschicht-Dielektrikumsschicht (208), die die zweite Isolierschicht (206) und die zweite Gate-Leiterbahn (207) bedeckt;
wobei die Leiterbahnen der Source-/Drain-Metallschicht auf der organischen Füllschicht (30) angeordnet sind, die Leiterbahnen der Source-/Drain-Metallschicht über ein erstes Durchkontaktierungsloch (901), das sich durch die erste Isolierschicht (204) erstreckt, mit der aktiven Schicht (203) verbunden sind, die zweite Isolierschicht (206) und die Zwischenschicht-Dielektrikumsschicht (208) verläuft, und die organische Füllschicht (30) zwischen den Leiterbahnen der Source-/Drain-Metallschicht und der Zwischenschicht-Dielektrikumsschicht (208) angeordnet ist;
wobei die organische Füllschicht (30) mit mindestens einer Rillenstruktur (301) versehen ist, die in einem dem Biegebereich (1a) entsprechenden Bereich angeordnet ist und sich auf einer vom Basissubstrat (10) abgewandten Seite befindet, und die erste Source-/Drain-Metallschicht-Leiterbahn (401) durch die Rillenstruktur (301) hindurch eine gekrümmte Leiterbahn bildet,
wobei zumindest ein Teil der Rillenstruktur (301) die organische Füllschicht (30) vollständig durchdringt, und
wobei die erste Source-/Drain-Metallschicht-Leiterbahn (401), wo die organische Füllschicht (30) durchdringt wird, zwischen der darunterliegenden Zwischenschicht-Dielektrikumsschicht (208), der zumindest teilweise durch die organische Füllschicht (30) umgegeben ist, und der darüberliegenden Planarisierungsschicht (50) angeordnet ist.

2. Flexibles Anzeigepanel (1) nach Anspruch 1, wobei ein unterer Abschnitt der Rillenstruktur (301) mit der organischen Füllschicht (30) in Kontakt steht und die erste Source-/Drain-Metallschicht-Leiterbahn (401) zwischen der organischen Füllschicht (30) und der Planarisierungsschicht (50) angeordnet ist.

3. Flexibles Anzeigepanel (1) nach Anspruch 1, wobei der Öffnungsdurchmesser der Rillenstruktur (301) zwischen 2 µm und 20 µm liegt.

4. Flexibles Anzeigepanel (1) nach Anspruch 1, wobei die Tiefe der Rillenstruktur (301) zwischen 0,5 µm und 1,5 µm liegt.

5. Flexibles Anzeigepanel (1) nach Anspruch 2, wobei die Querschnittsform der Rillenstruktur (301) ein Trapez, ein Rechteck, ein Quadrat, einen Kreis, eine Raute oder ein Dreieck aufweist.

6. Flexibles Anzeigepanel (1) nach Anspruch 1, wobei das flexible Anzeigepanel (1) ferner ein zweites Durchkontaktierungsloch umfasst, das im Biegebereich (1a) ausgebildet ist, wobei sich das zweite Durchkontaktierungsloch durch die dielektrische Zwischenschicht, die zweite Isolierschicht, die erste Isolierschicht und die Pufferschicht erstreckt und die organische Füllschicht (30) in das zweite Durchkontaktierungsloch eingefüllt ist.

7. Flexibles Anzeigepanel (1) nach Anspruch 1, wobei die Pufferschicht aus Siliziumnitrid oder Siliziumoxid besteht.

8. Verfahren zur Herstellung eines flexiblen Anzeigepanels (1) nach Anspruch 1, das folgende Schritte umfasst:
S10: Bereitstellen eines Basissubstrats (10);
S20: Aufbringen einer anorganischen Schicht (20) auf das Basissubstrat (10);
S30: Bilden einer organischen Füllschicht (30) auf der anorganischen Schicht (20) und Strukturieren der organischen Füllschicht (30), so dass die organische Füllschicht (30) mindestens eine Rillenstruktur (301) bildet, die in einem dem Biegebereich (1a) entsprechenden Bereich angeordnet ist und sich auf einer vom Basissubstrat (10) abgewandten Seite befindet;
S40: Ausbilden von Leiterbahnen der Source-/Drain-Metallschicht auf der organischen Füllschicht (30), und Strukturieren der Source-/Drain-Metallschicht, um eine erste Source-/Drain-Metallschicht-Leiterbahn (401) im Biegebereich (1a) und eine zweite Source-/Drain-Metallschicht-Leiterbahn (402) im nicht biegsamen Bereich (1b) zu bilden, wobei die erste Source-/Drain-Metallschicht-Leiterbahn (401) eine gekrümmte Leiterbahn durch die Rillenstruktur (301) bildet; und
S50: Bilden einer Planarisierungsschicht (50) auf der Leiterbahn der Source-/Drain-Metallschicht,
wobei die anorganische Schicht (20) Folgendes umfasst:
eine auf dem Basissubstrat (10) angeordnete Feuchtigkeitssperrschicht (201);
eine auf der Feuchtigkeitssperrschicht (201) angeordnete Pufferschicht (202);
eine auf der Pufferschicht (202) angeordnete aktive Schicht (203);
eine erste Isolierschicht (204), die die Pufferschicht (202) und die aktive Schicht (203) bedeckt;
eine erste Gate-Leiterbahn (205), die auf der ersten Isolierschicht (204) angeordnet ist;
eine zweite Isolierschicht (206), die die erste Isolierschicht (204) und die erste Gate-Leiterbahn (205) bedeckt;
eine zweite Gate-Leiterbahn (207), die auf der zweiten Isolierschicht (206) angeordnet ist; und
eine Zwischenschicht-Dielektrikumsschicht (208), die die zweite Isolierschicht (206) und die zweite Gate-Leiterbahn (207) bedeckt;
wobei die Leiterbahnen der Source-/Drain-Metallschicht auf der organischen Füllschicht (30) angeordnet sind, die Leiterbahnen der Source-/Drain-Metallschicht über ein erstes Durchkontaktierungsloch (901), das sich durch die erste Isolierschicht (204) erstreckt, mit der aktiven Schicht (203) verbunden sind, die zweite Isolierschicht (206) und die Zwischenschicht-Dielektrikumsschicht (208) verläuft, und die organische Füllschicht (30) zwischen den Leiterbahnen der Source-/Drain-Metallschicht und der Zwischenschicht-Dielektrikumsschicht (208) angeordnet ist;
wobei die organische Füllschicht (30) mit mindestens einer Rillenstruktur (301) versehen ist, die in einem dem Biegebereich (1a) entsprechenden Bereich angeordnet ist und sich auf einer vom Basissubstrat (10) abgewandten Seite befindet, und die erste Source-/Drain-Metallschicht-Leiterbahn (401) durch die Rillenstruktur (301) hindurch eine gekrümmte Leiterbahn bildet,
wobei zumindest ein Teil der Rillenstruktur (301) die organische Füllschicht (30) vollständig durchdringt, und
wobei die erste Source-/Drain-Metallschicht-Leiterbahn (401), die die organische Füllschicht (30) durchdringt, zwischen der darunterliegenden Zwischenschicht-Dielektrikumsschicht (208), der sie zumindest teilweise umgebenden organischen Füllschicht (30) und der darüberliegenden Planarisierungsschicht (50) angeordnet ist.

## Revendications

1. Panneau d'affichage flexible (1), comprenant une zone de flexion (1a) et une zone non flexible (1b), dans lequel le panneau d'affichage flexible (1) comprend :
un substrat de base (10) ;
une couche inorganique (20) disposée sur le substrat de base (10) ;
une couche de remplissage organique (30) disposée sur la couche inorganique (20) ;
des pistes de la couche métallique de source/drain disposées sur la couche de remplissage organique (30), les pistes de la couche métallique de source/drain comprenant une première piste (401) de la couche métallique de source/drain disposée dans la zone de flexion (1a) et une deuxième piste (402) de la couche métallique de source/drain disposée dans la zone non flexible (1b) ; et
une couche de planarisation (50) disposée d'un côté des pistes de la couche métallique source/drain, à l'opposé du substrat de base (10) ;
dans laquelle la couche inorganique (20) comprend :
une couche formant barrière contre l'humidité (201) disposée sur le substrat de base (10) ;
une couche tampon (202) disposée sur la couche barrière contre l'humidité (201) ;
une couche active (203) disposée sur la couche tampon (202) ;
une première couche isolante (204) recouvrant la couche tampon (202) et la couche active (203) ;
une première piste de couche de grille (205) disposée sur la première couche isolante (204) ;
une deuxième couche isolante (206) recouvrant la première couche isolante (204) et la première piste de couche de grille (205) ;
une deuxième piste de couche de grille (207) disposée sur la deuxième couche isolante (206) ; et
une couche diélectrique intercouche (208) recouvrant la deuxième couche isolante (206) et la deuxième piste de couche de grille (207) ;
dans lequel les pistes de la couche métallique source/drain sont disposées sur la couche de remplissage organique (30), les pistes de la couche métallique source/drain sont reliées à la couche active (203) par l'intermédiaire d'un premier trou de connexion (901) traversant la première couche isolante (204), la deuxième couche isolante (206) et la couche diélectrique intercouche (208), et la couche de remplissage organique (30) est disposée entre les pistes de la couche métallique de source/drain et la couche diélectrique intercouche (208) ;
dans lequel la couche de remplissage organique (30) est pourvue d'au moins une structure en rainure (301) agencée dans une zone correspondant à la région de flexion (1a) et disposée sur un côté opposé au substrat de base (10), et la première piste de la couche métallique de source/drain (401) forme une piste courbe à travers la structure en rainure (301),
dans laquelle au moins une partie de la structure en rainure (301) traverse entièrement la couche de remplissage organique (30), et
dans lequel la première piste de la couche métallique de source/drain (401), au niveau de laquelle la couche de remplissage organique (30) est traversée, est positionnée entre la couche diélectrique intercouche (208) située en dessous, la couche de remplissage organique (30) qui l'entoure au moins partiellement, et la couche de planarisation (50) située au-dessus.

2. Panneau d'affichage flexible (1) selon la revendication 1, dans lequel une partie inférieure de la structure en rainure (301) est en contact avec la couche de remplissage organique (30), et la première piste de la couche métallique de source/drain (401) est disposée entre la couche de remplissage organique (30) et la couche de planarisation (50).

3. Panneau d'affichage flexible (1) selon la revendication 1, dans lequel le diamètre des ouvertures de la structure en rainure (301) est compris entre 2 µm et 20 µm.

4. Panneau d'affichage flexible (1) selon la revendication 1, dans lequel la profondeur de la structure en rainure (301) est comprise entre 0,5 µm et 1,5 µm.

5. Panneau d'affichage flexible (1) selon la revendication 2, dans lequel la forme en coupe transversale de la structure en rainure (301) présente la forme d'un trapèze, d'un rectangle, d'un carré, d'un cercle, d'un losange ou d'un triangle.

6. Panneau d'affichage flexible (1) selon la revendication 1, dans lequel le panneau d'affichage flexible (1) comprend en outre un deuxième trou de passage défini dans la zone de flexion (1a), le deuxième trou de passage s'étendant à travers la couche diélectrique intercouche, la deuxième couche isolante, la première couche isolante et la couche tampon, et la couche de remplissage organique (30) remplissant le deuxième trou de passage.

7. Panneau d'affichage flexible (1) selon la revendication 1, dans lequel la couche tampon est constituée de nitrure de silicium ou d'oxyde de silicium.

8. Procédé de fabrication d'un panneau d'affichage flexible (1) selon la revendication 1, comprenant les étapes suivantes :
S10 : mise en place d'un substrat de base (10) ;
S20 : formation d'une couche inorganique (20) sur le substrat de base (10) ;
S30 : formation d'une couche de remplissage organique (30) sur la couche inorganique (20), et structuration de la couche de remplissage organique (30), de sorte que celle-ci forme au moins une structure en rainure (301) située dans une zone correspondant à la région de flexion (1a) et disposée sur un côté opposé au substrat de base (10) ;
S40 : formation de pistes de la couche métallique source/drain sur la couche de remplissage organique (30), et la mise en forme de la couche métallique de source/drain pour former une première piste de la couche métallique de source/drain (401) dans la zone de flexion (1a) et une deuxième piste de la couche métallique de source/drain (402) dans la zone non flexible (1b), la première piste de la couche métallique de source/drain (401) formant une piste courbe à travers la structure en rainure (301) ; et
S50 : formation d'une couche de planarisation (50) sur la piste de la couche métallique source/drain,
dans laquelle la couche inorganique (20) comprend :
une couche formant barrière contre l'humidité (201) disposée sur le substrat de base (10) ;
une couche tampon (202) disposée sur la couche barrière contre l'humidité (201) ;
une couche active (203) disposée sur la couche tampon (202) ;
une première couche isolante (204) recouvrant la couche tampon (202) et la couche active (203) ;
une première piste de couche de grille (205) disposée sur la première couche isolante (204) ;
une deuxième couche isolante (206) recouvrant la première couche isolante (204) et la première piste de couche de grille (205) ;
une deuxième piste de couche de grille (207) disposée sur la deuxième couche isolante (206) ; et
une couche diélectrique intercouche (208) recouvrant la deuxième couche isolante (206) et la deuxième piste de couche de grille (207) ;
dans lequel les pistes de la couche métallique source/drain sont disposées sur la couche de remplissage organique (30), les pistes de la couche métallique source/drain sont reliées à la couche active (203) par l'intermédiaire d'un premier trou de connexion (901) traversant la première couche isolante (204), la deuxième couche isolante (206) et la couche diélectrique intercouche (208), et la couche de remplissage organique (30) est disposée entre les pistes de la couche métallique de source/drain et la couche diélectrique intercouche (208) ;
dans lequel la couche de remplissage organique (30) est pourvue d'au moins une structure en rainure (301) agencée dans une zone correspondant à la région de flexion (1a) et disposée sur un côté opposé au substrat de base (10), et la première piste de la couche métallique de source/drain (401) forme une piste courbe à travers la structure en rainure (301),
dans laquelle au moins une partie de la structure en rainure (301) traverse entièrement la couche de remplissage organique (30), et
dans lequel la première piste de la couche métallique de source/drain (401), au niveau de laquelle la couche de remplissage organique (30) est traversée, est positionnée entre la couche diélectrique intercouche (208) située en dessous, la couche de remplissage organique (30) qui l'entoure au moins partiellement, et la couche de planarisation (50) située au-dessus.
